# EUROPEAN PATENT SPECIFICATION

(11) **EP 3 982 199 B1**
(45) Date of publication and mention of the grant of the patent: **04.10.2023**
(21) Application number: 20817739.4
(22) Date of filing: 09.05.2020
(51) Int. Cl.: G03F 7/24, G03F 7/20, B41J 2/47

(54) **CALIBRATION SYSTEM AND DRAWING DEVICE**
KALIBRIERSYSTEM UND ZEICHENVORRICHTUNG
SYSTÈME D'ÉTALONNAGE ET DISPOSITIF DE DESSIN

(30) Priority: 07.06.2019 JP 2019106791
(43) Date of publication of application: 13.04.2022
(73) Proprietor: Inspec Inc., Senboku City Akita, 014-0341 (JP)
(72) Inventor: SUGAWARA, Masashi, Senboku City, Akita 0140341 (JP)
(74) Representative: Winter, Brandl - Partnerschaft mbB
(86) International application number: PCT/JP2020/018752
(87) International publication number: WO 2020/246200

(56) References cited:
- WO-A1-2018/150996
- WO-A1-2018/150996
- JP-A- S6 491 026
- JP-A- H02 306 612
- JP-A- H09 325 291
- JP-A- H09 325 291
- JP-A- S60 124 938
- JP-A- 2005 345 614
- JP-A- 2019 032 539
- US-A1- 2015 324 968

## Description

### TECHNICAL FIELD

The present invention relates to calibration systems for calibrating an exposure light beam for drawing a pattern on a substrate and to drawing devices.

### BACKGROUND ART

In recent years, the amount of electronics used in transportation machines such as automobiles and aircraft has been steadily increasing. Along with this, the number of wire harnesses used for power supply and/or signal transmission and reception with respect to the electronics is also increasing. On the other hand, weight reduction and space saving are required in the transportation machines, and an increase in weight and space occupation due to the increase of the wire harnesses is therefore becoming a problem.

In view of these problems, investigations have been made to replace the wire harnesses used in transportation machines with long sheet-like flexible printed circuits (FPCs).

As a technique for forming patterns on a long sheet-like substrate, for example, PTL 1 discloses a substrate processing apparatus provided with: a support member having a support surface for supporting a long sheet-like substrate, the support member being provided with reference marks at a plurality of positions on the support surface with respect to the width direction intersecting with the longitudinal direction of the substrate; a conveyance device for moving the substrate supported on the support member in the longitudinal direction; and a drawing device including a plurality of drawing units for scanning ranges smaller than the dimension in the width direction of the substrate while projecting beam spot light onto the support surface or the substrate supported on the support surface, the plurality of drawing units being capable of drawing predetermined patterns along drawing lines obtained from the scan. The plurality of drawing units are arranged in the width direction of the substrate such that the patterns drawn on the substrate by the respective drawing lines of the plurality of drawing units are joined together in the width direction of the substrate in association with the movement of the substrate in the longitudinal direction.

NPTL 1 discloses a technique of performing alignment measurement, overlay exposure and workpiece replacement in parallel, in order to perform a process while continuously conveying the film by a roll-to-roll method without stopping the film from being conveyed.

PTL 2 discloses a pattern rendering method, in which a pattern is rendered on a substrate (P) by causing the substrate (P) to move in a sub-scanning direction while a rendering beam (LBn) modulated to be on or off in accordance with the pattern is scanned across the substrate (P) in a main scanning direction by means of a polygon mirror (PM).

PTL 3 discloses improving accuracy in detecting the position of a beam waist all over the scanning range in an optical scanner. In the optical scanner, the width of the aperture of a light beam diaphragm plate is enlarged (108), the numerical aperture of an optical system is increased.

PTL 4 discloses an optical apparatus, which includes a mount to hold a workpiece. An array of optical heads project respective patterns of radiation onto the workpiece. A calibration assembly captures images of the respective patterns. A motion assembly, on which the calibration assembly is mounted, transports the calibration assembly among a plurality of different positions between the array of the optical heads and the mount so as to intercept and image, at each of the different positions, a respective pattern projected by a different one of the optical heads.

PTL 5 discloses techniques to accurately detect the position of image-drawing laser beams without being influenced by the ON-OFF operation of an ultrasonic photo modulation element by method wherein a laser beam incident to an ultrasonic photo modulator is split into a monitor beam M through a beam splitter, which is then made again incident to an optical system including a polygonal mirror and an image- forming lens, leading to the detection of the image-drawing laser beam.

### PRIOR ART DOCUMENTS

### PATENT LITERATURE

PTL 1: WO2015/152217
PTL 2: WO 2018150996 A1
PTL 3: JP H09325291 A
PTL 4: US 20150324968 A1
PTL 5: JP S60124938 A

### NON-PATENT LITERATURE

NPTL 1: Yoshiaki Kito, et al., "Direct Imaging Exposure Equipment with High Overlay Accuracy for Flexible Substrate in Roll-to-Roll Method," Journal of the Institute of Image Information and Television Engineers, Vol. 71, No. 10, pp. J230-J235 (2017), the Institute of Image Information and Television Engineers, September 8, 2017

### SUMMARY OF THE INVENTION

### PROBLEMS TO BE SOLVED BY THE INVENTION

Incidentally, in equipment requiring a high level of safety, such as automobiles and aircraft, traceability is required to ensure the high reliability of each component constituting the equipment. For this reason, regarding the patterned substrate, in the step of patterning the substrate, it is necessary to periodically perform calibration for checking positional precision of exposure beam irradiation and the like, and to store the calibration data.

Regarding calibration, PTL 1 discloses a technique in which reference patterns formed on an outer periphery of a rotating drum is irradiated with drawing beams and adjustment information (calibration information) corresponding to an arrangement condition or a mutual arrangement error of the drawing lines by the drawing beams is determined based on the reflected light of the drawing beams. PTL 1 requires, when performing calibration, the reference patterns formed on the outer periphery of the rotating drum to be irradiated with the beams, and thus, calibration needs to be performed without setting the substrate, or a substrate with sufficient translucency to allow a beam to pass therethrough needs to be re-set (see paragraph 0147 of citation 1).

However, for example, in order to replace the wire harnesses used in an automobile with FPCs, it is necessary to form a continuous wiring pattern of several meters in length (e.g., 6 m or more) on a substrate. In the case of forming a continuous pattern on a long substrate as described above, it is very labor-intensive to remove the substrate and/or to re-set a substrate for calibration each time calibration is performed, and it is also impractical because there is a risk of deterioration in the alignment precision. In short, in the case of forming a continuous pattern on a long substrate, it is very difficult to perform calibration as needed with the technique disclosed in PTL 1.

The present invention has been made in view of the above, and an object of the present invention is to provide, in the case of continuously forming a pattern on a long sheet-like substrate, a calibration system and a drawing device that can perform, as needed, calibration of an exposure beam radiated onto the substrate.

### MEANS FOR SOLVING THE PROBLEMS

The above problem is solved by the subject matter of the independent claims. Further aspects of the subject matter are described in the dependent claims.

In order to solve the above-described problems, the calibration system, which is an aspect of the present disclosure, is a calibration system for performing calibration in a drawing device. The drawing device includes at least one exposure head that emits a beam for exposure toward an exposure surface of the substrate. The substrate has a long-sheet shape and is conveyed in a longitudinal direction by being supported on part of an outer periphery of a conveying drum having a cylindrical shape. The calibration system is provided with: an optical system that is provided insertably into and removably from an optical path of a beam that is emitted from the exposure head and enters the exposure surface, the optical system guiding at least part of the beam in a direction different from that of the optical path when the optical system is inserted into the optical path; a movement mechanism that inserts and removes the optical system into and from the optical path; and an optical sensor having a light-receiving surface for receiving at least part of the beam that is guided by the optical system when the optical system is inserted into the optical path, the optical sensor outputting a detection signal by detecting an irradiation position and an irradiation intensity at the light-receiving surface of at least part of the beam that has entered the light-receiving surface.

In the above-described calibration system, the exposure surface when the optical system is removed from the optical path and the light-receiving surface when the optical system is inserted into the optical path may be conjugated.

In the above-described calibration system, the length of the optical path of the beam from the exposure head to the exposure surface when the optical system is removed from the optical path may be equal to the length of the optical path of the beam from the exposure head to the light-receiving surface when the optical system is inserted into the optical path.

In the above-described calibration system, the optical system and the optical sensor may be provided as units with positions fixed relative to each other, and the movement mechanism may insert and remove the units into and from the optical path.

In the above-described calibration system, the position of the optical sensor is fixed, and there may be further provided: a second optical system that further guides at least part of the beam, guided by the optical system in a direction different from that of the optical path, in a direction toward the light-receiving surface of the optical sensor; and a third optical system that allows at least part of the beam guided by the second optical system to be imaged on the light-receiving surface.

In the above-described calibration system, there may be further provided: a control part that generates, based on the detection signal output from the optical sensor, data representing an irradiation position and an irradiation intensity at the light-receiving surface of at least part of the beam emitted from the exposure head; and a storage part that stores the data representing the irradiation position and the irradiation intensity as calibration data.

In the above-described calibration system, the storage part may further store reference data representing a reference irradiation position and a reference irradiation intensity at the light-receiving surface corresponding to a predetermined irradiation position and a predetermined irradiation intensity of the beam at the exposure surface, and the control part may include a determination part that determines, based on the calibration data and the reference data, whether an irradiation position and an irradiation intensity of a beam that has entered the light-receiving surface fall within ranges of predetermined reference values.

In the above-described calibration system, the control part may generate, based on the determination result by the determination part, correction value data for correcting at least either the irradiation position or the irradiation intensity of the beam emitted from the exposure head if at least either the irradiation position or the irradiation intensity of the beam that has entered the light-receiving surface fails to fall within the range of the reference value, and the storage part may further store the correction value data.

In the above-described calibration system, the exposure head may include: a light source that outputs laser light; a beam-shaping optical system that generates a beam by shaping the laser light into a beam shape; a polygon mirror that causes the beam generated by the beam-shaping optical system to scan; and a drive part that rotates the polygon mirror, and the control part may correct at least either the irradiation intensity or the irradiation position of the beam emitted from the exposure head by controlling at least either the output of the light source or operation of the drive part based on the correction value data.

In the above-described calibration system, there may be further provided an adjustment mechanism that adjusts the distance between the exposure head and the conveying drum, and the control part may acquire, based on the detection signal representing the irradiation position of the beam output from the optical sensor, the diameter of the beam at the light-receiving surface and control the adjustment mechanism based on the diameter of the beam.

A drawing device, which is another aspect of the present disclosure, is provided with: a conveying drum that has a cylindrical shape, the conveying drum supporting a long sheet-like substrate on part of an outer periphery and conveying the substrate by rotating about a central shaft of the cylinder; at least one exposure head that emits a beam for exposure toward an exposure surface of the substrate; and at least one calibration system that performs calibration of the at least one exposure head. The calibration system includes: an optical system that is provided insertably into and removably from an optical path of the beam that is emitted from the exposure head and enters the exposure surface, the optical system guiding at least part of the beam in a direction different from that of the optical path when the optical system is inserted into the optical path; a movement mechanism that inserts and removes the optical system into and from the optical path; and an optical sensor having a light-receiving surface for receiving at least part of the beam that is guided by the optical system when the optical system is inserted into the optical path, the optical sensor outputting a detection signal by detecting an irradiation position and an irradiation intensity at the light-receiving surface of at least part of the beam that has entered the light-receiving surface.

### EFFECT OF THE INVENTION

According to the present invention, by inserting, during calibration, the optical system into the optical path of a beam that is emitted from the exposure head and enters the substrate, the beam is guided in a direction different from that of the optical path and enters the light-receiving surface of the optical sensor, calibration can therefore be performed while the substrate remains set on the conveying drum. Therefore, in the case of continuously forming a pattern on a long sheet-like substrate, calibration can be performed as needed.

### BRIEF DESCRIPTION OF THE DRAWINGS

[FIG. 1] FIG. 1 is a schematic diagram showing a schematic configuration of a drawing device including a calibration system.
[FIG. 2] FIG. 2 is a plan view of the drawing device shown in FIG. 1.
[FIG. 3] FIG. 3 is a schematic diagram showing a schematic configuration of the inside of an exposure head.
[FIG. 4] FIG. 4 is a schematic diagram of the exposure head shown in FIG. 1 as seen from the substrate side.
[FIG. 5] FIG. 5 is a schematic diagram illustrating a substrate on which a pattern is formed.
[FIG. 6] FIG. 6 is an enlarged schematic diagram showing a neighborhood of a calibration unit shown in FIG. 1.
[FIG. 7] FIG. 7 is a schematic diagram of a sensor unit shown in FIG. 6 as seen from the light-receiving surface side.
[FIG. 8] FIG. 8 is a block diagram showing a schematic configuration of a controller shown in FIG. 1.
[FIG. 9] FIG. 9 is a flowchart illustrating operations at the time of calibration of the drawing device shown in FIG. 1.
[FIG. 10] FIG. 10 is a schematic diagram showing a schematic configuration of a drawing device including a calibration system according to an embodiment of the present invention.
[FIG. 11] FIG. 11 is an enlarged schematic diagram showing a neighborhood of a calibration unit shown in FIG. 10.

### EMBODIMENTS OF THE INVENTION

Hereinafter, a calibration system and a drawing device according to embodiments of the present invention will be described with reference to the drawings. It should be noted that the present invention is not limited by these embodiments. In the description of each drawing, the same portions are denoted by the same reference numbers.

The drawings referred to in the following description are merely schematic representations of shape, size, and positional relationship to the extent that the subject matter of the present invention may be understood. In other words, the present invention is not limited only to the shapes, sizes, and positional relationships exemplified in the respective figures. In addition, the drawings may also include, among themselves, portions having different dimensional relationships and ratios from each other.

### Example

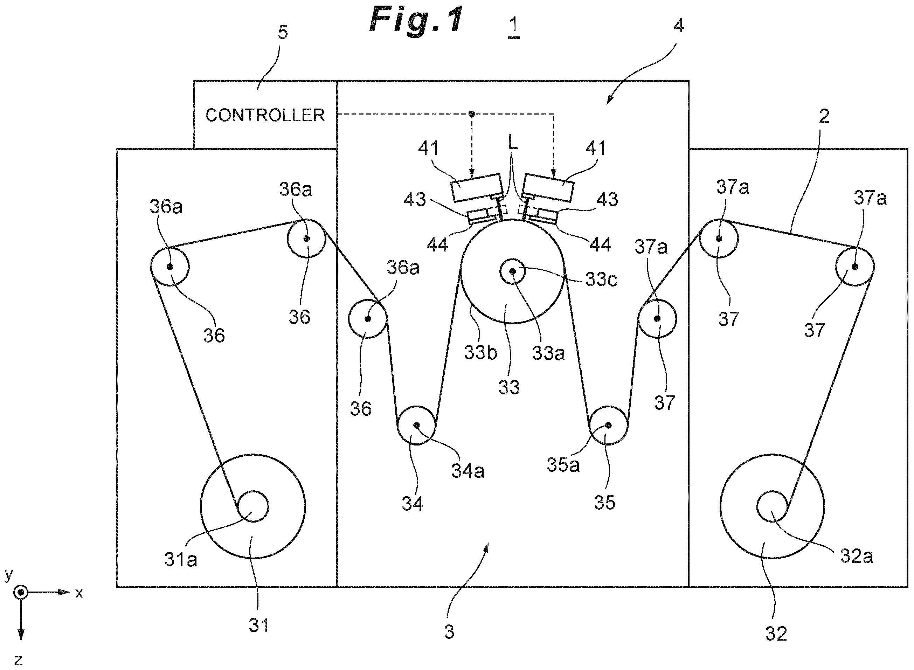

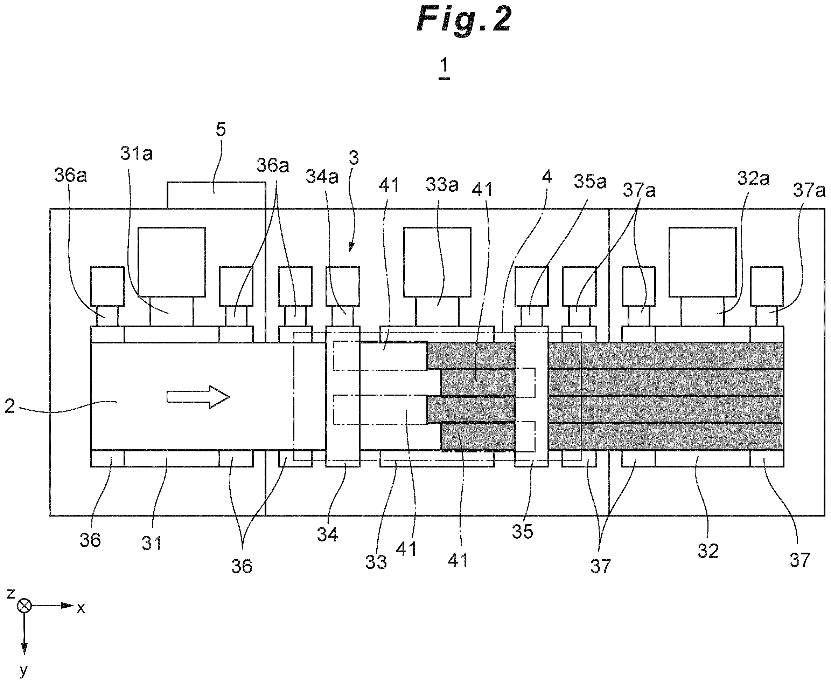

FIG. 1 is a schematic diagram showing a schematic configuration of a drawing device including a calibration system not according to the present invention. FIG. 2 is a plan view of the drawing device. As shown in FIGS. 1 and 2, the drawing device 1 includes a conveying system 3 for conveying a substrate 2 having a long-sheet shape, a drawing unit 4 for forming a pattern by irradiating the substrate 2 with a beam L for exposure, and a controller 5 for controlling the operation of the conveying system 3 and the drawing unit 4. In the following, the conveying direction of the substrate 2 will be referred to as the x direction, the width direction of the substrate 2 will be referred to as the y direction, and the vertical direction will be referred to as the z direction (positive in the downward direction).

In the present example, a flexible printed circuit (FPC) is used as the substrate 2 to be processed. The FPC is a flexible circuit substrate in which a metal foil such as copper is bonded to a base film made of an insulating resin such as polyimide. The substrate 2 is, for example, a strip-shaped FPC of several meters to several tens of meters in length, and the substrate is unwound from a state of being wound in a roll on an unwinding reel 31 and is wound on a take-up reel 32 after a pattern is formed thereon by the drawing unit 4 while being conveyed by the conveying system 3. Thus, this method of conveying in which the strip-shaped workpiece is unwound from a roll and wound around a roll after application of predetermined processing is referred to as a "roll-to-roll" method.

In the conveying system 3, a rotary shaft 31a for rotatably supporting the unwinding reel 31, a rotary shaft 32a for rotatably supporting the take-up reel 32, a conveying drum 33, tension pulleys 34, 35 provided respectively on the upstream side (left side in FIG. 1) and the downstream side (right side in FIG. 1) of the conveying drum 33, and a plurality of guide rollers 36, 37 are provided.

The conveying drum 33 generally has a cylindrical shape and is supported by a rotary shaft 33a which rotates by the rotational driving force supplied from a drive source. The conveying drum 33 supports the substrate 2 in a region of substantially the upper half of the outer periphery 33b thereof, and conveys the substrate 2 as the conveying drum rotates. Further, the conveying drum 33 is provided with an encoder 33c for measuring the amount of rotation of the conveying drum 33.

The two tension pulleys 34, 35 are respectively rotatably supported on rotary shafts 34a, 35a which are movable in the vertical direction, and are located below the conveying drum 33. A tension adjusting mechanism for biasing the rotary shaft 34a, 35a downward is coupled to each rotary shaft 34a, 35a. The substrate 2 wound around the conveying drum 33 can be conveyed with a predetermined tension applied thereon by biasing the tension pulleys 34, 35 downward via the rotary shafts 34a, 35a by means of the tension adjusting mechanism.

Each guide roller 36 is rotatably supported on a rotary shaft 36a and guides the substrate 2 unwound from the unwinding reel 31 to the upstream-side tension pulley 34. Each guide roller 37 is rotatably supported on a rotary shaft 37a and guides the substrate 2 that has been applied with pattern-forming processing from the downstream-side tension pulley 35 to the take-up reel 32.

The configuration of the conveying system 3 is not limited to the configurations shown in FIGS. 1 and 2, as long as the substrate 2 is conveyed in the roll-to-roll method and the pattern-forming processing can be applied to the substrate 2 supported on the outer periphery 33b of the conveying drum 33 . Further, a unit (a pre-processing unit, a post-processing unit, etc.) may be provided for performing different processing between unwinding of the substrate 2 from the unwinding reel 31 and reaching thereof to the conveying drum 33, or between removal of the substrate 2 from the conveying drum 33 and winding thereof on the take-up reel 32. Typically, an edge position control (EPC) device is provided which detects the edge position of the substrate 2 and finely moves the unwinding device or the take-up device in the conveying system 3 in order to prevent meandering during conveying of the substrate.

In the drawing unit 4, a plurality of exposure heads 41 that emit beams L for exposure toward the substrate 2, and calibration units 43 and movement mechanisms 44, which are used when calibrating the beams L, are provided. In the present embodiment, the calibration unit 43 and the movement mechanism 44, together with the controller 5 described below, constitute the calibration system.

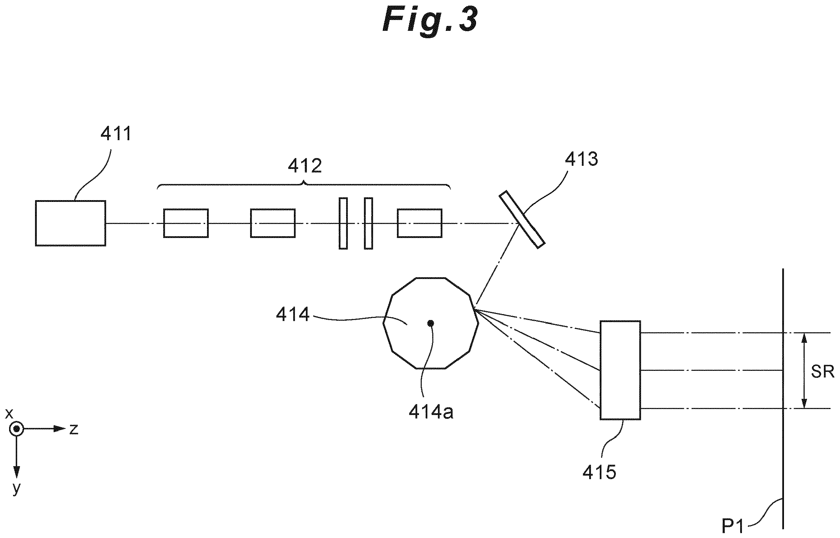

The exposure head 41 directly draws a pattern, such as a circuit or a wiring, on the substrate 2 by radiating the beam L onto the substrate 2 supported on the conveying drum 33. FIG. 3 is a schematic diagram showing a schematic configuration of the inside of an exposure head.

As shown in FIG. 3, a laser light source 411 for outputting laser light, a beam-shaping optical system 412, a reflecting mirror 413, a polygon mirror 414, and an imaging optical system 415 are provided inside the exposure head 41. Among which, the polygon mirror 414 is provided with a drive device for rotating the polygon mirror 414 about a rotary shaft 414a.

The beam-shaping optical system 412 includes an optical element, such as a collimator lens, a cylindrical lens, a light amount adjusting filter, and a polarizing filter, and shapes the laser light output from the laser light source 411 into the beam L having a spot-shaped beam shape. The reflecting mirror 413 reflects the beam L shaped by the beam-shaping optical system 412 in the direction of the polygon mirror 414. The polygon mirror 414 rotates around the rotary shaft 414a and reflects the beam L incident from the direction of the reflecting mirror 413 in a plurality of directions in the plane orthogonal to the rotary shaft 414a. The imaging optical system 415 includes an optical element, such as an fθ lens or a telecentric fθ lens, and causes the beam L reflected by the polygon mirror 414 to be imaged on an exposure surface P1 of the substrate 2 supported on the outer periphery of the conveying drum 33. In such exposure head 41, the beam L emitted from the exposure head 41 can be caused to scan one-dimensionally in a predetermined scan range SR by controlling the rotation of the polygon mirror 414.

The configuration of the exposure head 41 is not limited to the configuration illustrated in FIG. 3, as long as the beam L can be imaged on the exposure surface P1 and can be scanned one-dimensionally thereon. For example, the emitting direction of the beam L may be changed by arranging a reflecting mirror between the polygon mirror 414 and the imaging optical system 415.

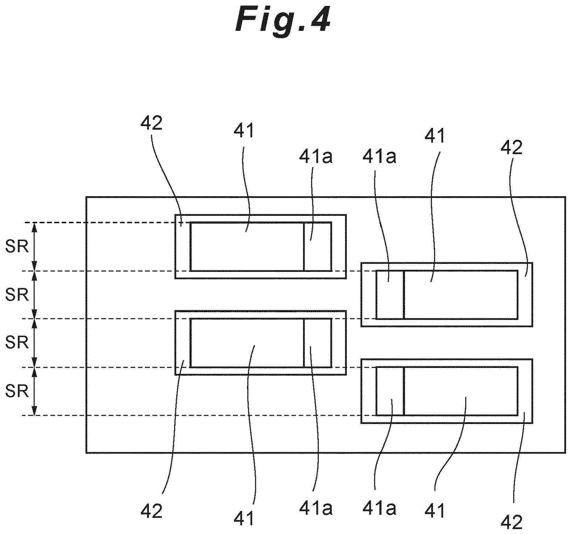

FIG. 4 is a plan view of the plurality of exposure heads 41 provided in the drawing unit 4 as seen from the substrate 2 side. Although four exposure heads 41 are shown in FIG. 4, the number of exposure heads 41 is not limited thereto. The number of exposure heads 41 may be one or more, and can be appropriately configured according to the width of the substrate 2, the scan range SR (see FIG. 3) and the beam power of the exposure head 41, and the like.

Each exposure head 41 is mounted to a support mechanism provided inside the drawing unit 4 via an adjustment stage 42. The adjustment stage 42 is provided for manually fine-adjusting the position of the exposure head 41 in the x and y directions as well as the angle with respect to the vertical direction. These exposure heads 41 are arranged such that the edges of the scan ranges SR of the beams L emitted from beam emitting ports 41a slightly overlap each other or are adjacent to each other without any space therebetween, between the beams L that scan the adjacent regions in the width direction (y direction) of the substrate 2. Thereby, scanning can be performed without any space in the width direction of the substrate 2 by means of the plurality of beams L. In addition, the distance of each exposure head 41 from the conveying drum 33 is adjusted such that the beam L is focused on the exposure surface of the substrate 2.

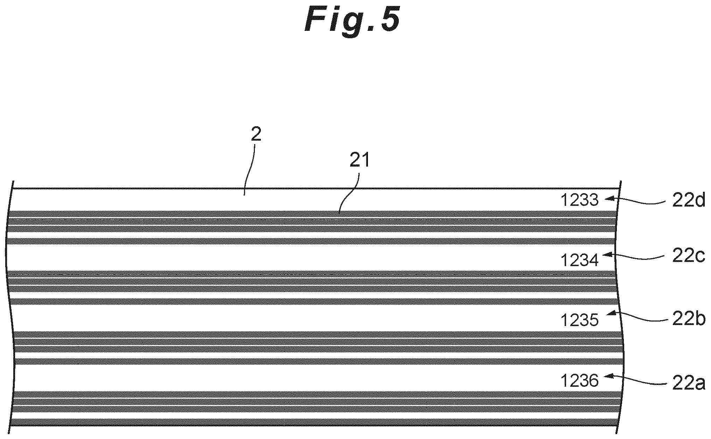

FIG. 5 is a schematic diagram illustrating the substrate 2 on which a pattern is formed by the drawing unit 4. The two-dimensional exposure pattern 21 is formed on the substrate 2 by conveying the substrate 2 by means of the conveying drum 33 while the beam L emitted from each exposure head 41 shown in FIG. 4 is scanned in the width direction of the substrate 2. In this way, a continuous exposure pattern 21 can be formed on the long substrate 2, as shown in FIG. 5, by conveying the substrate 2 while the direct drawing is performed by the beam L.

In the drawing unit 4, a region to be exposed by each exposure head 41 may be preset with respect to the substrate 2. Therefore, an identification mark (ID) 22a to 22d for identifying an individual product and/or pattern may be drawn in the exposure region of each exposure head 41. A high level of traceability can be ensured by managing the identification marks 22a to 22d in association with data such as a lot number, a drawing device number, an exposure head number, and/or a date and time of exposure.

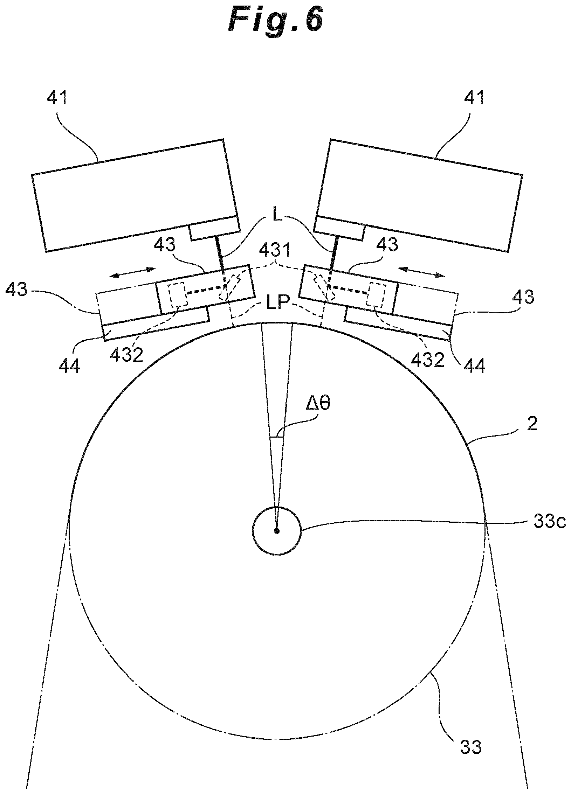

FIG. 6 is an enlarged schematic diagram showing a neighborhood of the calibration unit 43 shown in FIG. 1, and shows the arrangement at the time of calibration.

The movement mechanism 44 inserts and removes the calibration unit 43 into and from an optical path LP of the beam L that is emitted from the exposure head 41 and enters the exposure surface of the substrate 2. The movement mechanism 44 is, for example, a single-axis actuator, and inserts the calibration unit 43 into the optical path LP at the start of calibration (see FIG. 6) and removes the calibration unit 43 from the optical path LP when the calibration is completed (see FIG. 1). Such calibration unit 43 and movement mechanism 44 are provided for each exposure head 41.

The configuration of the movement mechanism 44 is not particularly limited, as long as it can move the calibration unit 43 with high precision. In addition, the calibration unit 43 is moved along the direction of conveyance of the substrate 2 (the tangential direction of the outer periphery of the conveying drum 33) at the irradiation position of the beam L in FIGS. 1 and 6; however, the direction of movement is not limited thereto. For example, the calibration unit 43 may be moved along the width direction (y direction) of the substrate 2.

A reflecting mirror 431 and a sensor unit 432 are provided in the calibration unit 43. The relative positions of the reflecting mirror 431 and the sensor unit 432 are fixed. The reflecting mirror 431 is an optical system that is arranged on the optical path LP when the calibration unit 43 is inserted into the optical path LP and guides the beam L in a direction different from that of the optical path LP.

The sensor unit 432 has a two-dimensional light-receiving surface and is provided at a position where the beam L reflected by the reflecting mirror 431 can enter the light-receiving surface. The length of an optical path from the position of the reflecting mirror 431 arranged in the optical path LP to the exposure surface of the substrate 2 at the time of calibration is equal to the length of an optical path from the position of the reflecting mirror 431 to the light-receiving surface of the sensor unit 432 at the time of calibration, and the light-receiving surface of the sensor unit 432 and the exposure surface of the substrate 2 to be exposed by the beam L are conjugated. In other words, at the light-receiving surface of the sensor unit 432 when the reflecting mirror 431 is inserted into the optical path LP, the same image of the beam L can be obtained as that at the exposure surface of the substrate 2 when the reflecting mirror 431 is not inserted into the optical path LP.

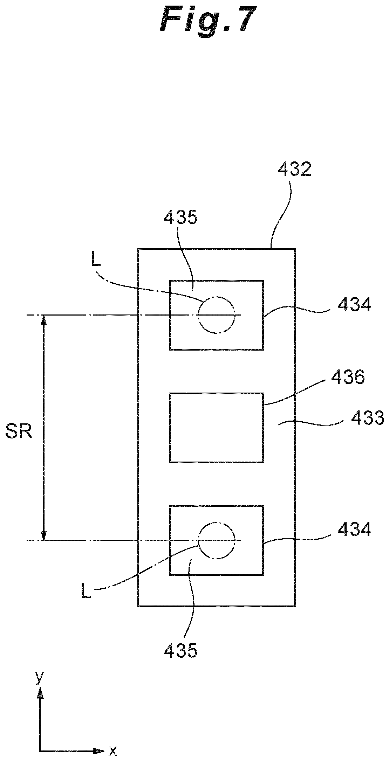

FIG. 7 is a schematic diagram of the sensor unit 432 as seen from the light-receiving surface side. As shown in FIG. 7, the sensor unit 432 includes a sensor substrate 433, and a position detecting element (PSD) 434 and a light intensity detecting element 436, which are optical sensors mounted on the sensor substrate 433. A circuit is formed on the sensor substrate 433 for processing the signals output from the position detecting element 434 and the light intensity detecting element 436.

The position detecting element 434 has a two-dimensional light-receiving surface 435 for receiving the beam L, and outputs a detection signal representing an irradiation position of the beam L that has entered the light-receiving surface 435. As shown in FIG. 7, in the present example, two position detecting elements 434 are arranged on the sensor substrate 433. The positions of these position detecting elements 434 are set so that the center line of each position detecting element 434 overlaps the line of the edge of the scan range SR. In this way, a slight deviation of the irradiation position of the beam L can be detected by providing two position detecting elements 434 with respect to a single sensor unit 432.

The light intensity detecting element 436 is, for example, a photodiode (PD), and outputs a detection signal representing the irradiation intensity of the beam L that has entered the light-receiving surface.

It should be noted that a single type of optical sensor may be used instead of the position detecting element and the light intensity detecting element if it can detect both the position and intensity of the beam L that has entered the light-receiving surface with high precision. In this case, such optical sensor may preferably be arranged at the positions (two locations) of the position detecting elements 434.

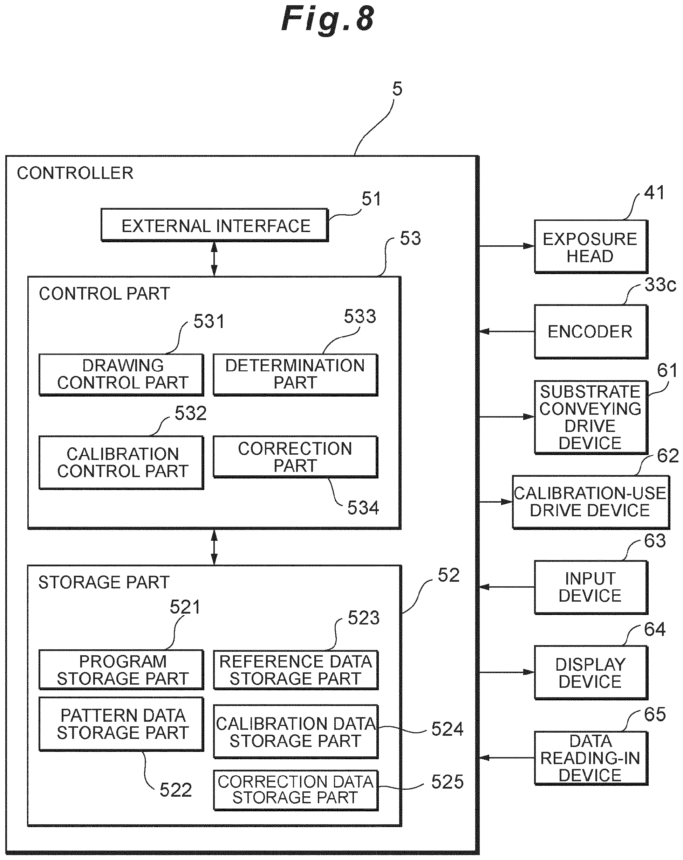

FIG. 8 is a block diagram showing a schematic configuration of the controller 5. The controller 5 is a device for comprehensively controlling the operation of each component of the drawing device 1, and includes an external interface 51, a storage part 52, and a control part 53.

The external interface 51 is an interface for connecting various external devices to the controller 5. Examples of the external devices connectable to the controller 5 include the exposure head 41, the encoder 33c, a substrate conveying drive device 61 for driving the conveying system 3, a calibration-use drive device 62 for driving the movement mechanism 44 of the calibration unit 43, an input device 63 such as a keyboard or a mouse, a display device 64 such as a liquid crystal monitor, and a data reading-in device 65 for reading in pattern data or the like into the controller 5.

The storage part 52 is configured by using a computer readable storage medium such as a disk drive and/or a semiconductor memory (e.g., a ROM or RAM). The storage part 52 stores, in addition to an operating system program and a driver program, a program for causing the controller 5 to execute a predetermined operation, various types of data and setting information used during execution of the program, and the like.

Specifically, the storage part 52 includes a program storage part 521, a pattern data storage part 522, a reference data storage part 523, a calibration data storage part 524, and a correction data storage part 525. The program storage part 521 stores the various types of programs described above. The pattern data storage part 522 stores data representing patterns to be drawn by the drawing unit 4. The reference data storage part 523 stores reference data (reference values) of the irradiation positions and irradiation intensities of the beams L. Here, the reference data refers to data representing: an irradiation position (hereinafter also referred to as a reference irradiation position) in the light-receiving surface 435 of the position detecting element 434 corresponding to a predetermined irradiation position of the beam L in the exposure surface of the substrate 2; and an irradiation intensity (hereinafter also referred to as a reference irradiation intensity) at the light intensity detecting element 436 corresponding to a predetermined irradiation intensity of the beam L at the exposure surface of the substrate 2. The calibration data storage part 524 stores calibration data of the beam L to be exposed on the substrate 2, in other words, it stores data representing the irradiation position of the beam L in the light-receiving surface 435 of the position detecting element 434 and the irradiation intensity of the beam L that has entered the light intensity detecting element 436. The correction data storage part 525 stores correction data for adjusting the exposure head 41 based on the calibration data.

The control part 53 is configured by using hardware such as a central processing unit (CPU), and reads in the programs stored in the program storage part 521 to perform data transfer and instruction to each component of the controller 5 and the drawing device 1, and comprehensively controls the operation of the drawing device 1 to execute the pattern-forming processing on the substrate 2. Further, by reading in the calibration program stored in the program storage part 521, the control part 53 periodically performs calibration of the exposure head 41, stores the calibration data, and adjusts the exposure head 41 based on the calibration data.

Specifically, functional parts implemented by the control part 53 executing the above-described program include a drawing control part 531, a calibration control part 532, a determination part 533, and a correction part 534.

The drawing control part 531 reads out the pattern data from the pattern data storage part 522, generates control data such as the power and scanning of the beam L by each exposure head 41 and the conveying speed of the substrate 2 by the conveying system 3, and outputs the control data to the exposure head 41 and the substrate conveying drive device 61. Thereby, the substrate 2 is conveyed at a predetermined speed by the conveying system 3, and a predetermined exposure region of the substrate 2 is irradiated and scanned in the width direction with the beam L emitted from each exposure head 41. In this manner, a two-dimensional pattern is continuously formed on the substrate 2.

The calibration control part 532 performs control for calibrating the beam L emitted from the exposure head 41 and generates data (calibration data) representing the measured values (calibration values) of the irradiation position of the beam L in the light-receiving surface 435 of the position detecting element 434 and the irradiation intensity at the light intensity detecting element 436.

The determination part 533 determines whether the calibration values are within the reference values based on the reference data stored in the reference data storage part 523 and the calibration data.

The correction part 534 generates correction data for correcting the irradiation position and the irradiation intensity of the beam L if the calibration values fail to fall within the reference values, and controls each component based on the correction data.

It should be noted that the controller 5 may be configured by a single piece of hardware or may be configured by combining a plurality of pieces of hardware.

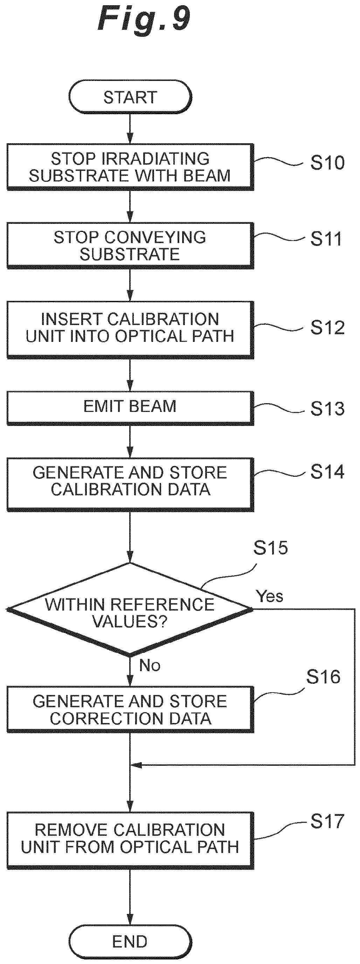

Next, an example of a calibration method will be described. FIG. 9 is a flowchart illustrating the operation at the time of calibration of the drawing device 1.

First, in step S10, the controller 5 causes each exposure head 41 to stop irradiating the substrate 2 with the beam L.

In the subsequent step S11, the controller 5 causes the conveying system 3 to stop conveying the substrate 2.

In the subsequent step S12, the controller 5 controls the calibration-use drive device 62 to drive the movement mechanism 44 so as to insert the calibration unit 43 into the optical path LP (see FIG. 6).

In the subsequent step S13, the controller 5 causes each exposure head 41 to emit the beam L. The beam L emitted from the exposure head 41 is reflected by the reflecting mirror 431 in the calibration unit 43, and enters the position detecting element 434 and the light intensity detecting element 436 in the sensor unit 432. Thereby, each position detecting element 434 outputs a detection signal representing the irradiation position of the beam L on the light-receiving surface 435, while the light intensity detecting element 436 outputs a detection signal representing the irradiation intensity of the beam L.

In the subsequent step S14, the calibration control part 532 of the controller 5 generates, based on the detection signals output from the position detecting element 434 and the light intensity detecting element 436, data (calibration data) representing the measured values of the irradiation position and the irradiation intensity of the beam L that has entered the light-receiving surface 435 and stores such data in the calibration data storage part 524.

In the subsequent step S15, the determination part 533 compares the calibration data generated in step S14 with the reference data stored in the reference data storage part 523 in order to determine whether the irradiation position and the irradiation intensity of the beam L emitted from each exposure head 41 are within the reference values. Specifically, the determination part 533 calculates the difference (Δx, Δy) of the measured value of the irradiation position with respect to the reference irradiation position of the beam L and the difference of the measured value of the irradiation intensity with respect to the reference irradiation intensity. Then, a determination is made as to whether the difference of the irradiation position (Δx, Δy) and the difference of the irradiation intensity are equal to or less than predetermined thresholds.

If the irradiation position and the irradiation intensity of the beam L are within the reference values (step S15: Yes), the operation proceeds to step S17.

On the other hand, if the irradiation position and the irradiation intensity of the beam L exceed the reference values (step S15: No), the correction part 534 generates correction data for correcting the position of each exposure head 41 and the power value of the beam L, and stores such correction data in the correction data storage part 525 (step S16). At this time, the correction part 534 may display the correction data on the display device 64. Specifically, the correction part 534 corrects the parameter of the output start position (the value of θ at the time of starting the output of the beam L) based on the difference Δx in order to adjust the drawing start point that is set using the signal (see Δθ in FIG. 6) of the encoder 33c in the conveying drum 33. Further, the correction part 534 corrects the parameter of the output start position (the initial position of the polygon mirror at the time of starting the output of the beam L) based on the difference Δy in order to adjust the drawing start point serving as a reference of the beam L emitted via the polygon mirror 414 (see FIG. 3). Further, regarding the irradiation intensity, the correction part 534 corrects the output parameter for each exposure head 41 used in the drawing control part 531.

In the subsequent step S17, the controller 5 controls the calibration-use drive device 62 to drive the movement mechanism 44 so as to remove the calibration unit 43 from the optical path LP (see FIG. 1). Thereby, the calibration operation in the drawing device 1 ends. When the drawing operation is restarted after completion of the calibration, each component operates based on the parameters corrected in step S16, and the drawing with respect to the substrate 2 can be performed with the corrected irradiation position and irradiation intensity of the beam.

As described above, since the beam L emitted from each exposure head 41 is scanned in the width direction as the substrate 2 is directly irradiated with the beam L while the substrate 2 is conveyed by the conveying drum 33, a two-dimensional exposure pattern can therefore be continuously formed without interruption on the substrate 2. Therefore, a continuous pattern can be efficiently formed on a long substrate ranging from several meters to several tens of meters in length, and an improvement in throughput can be achieved.

Further, a high level of traceability can be ensured at the pattern or wiring level by drawing an identification mark in the exposure region of each exposure head 41 with such exposure head 41.

Further, since a light source is provided in each exposure head 41, pattern-forming can be performed with sufficient irradiation intensity.

Further, by inserting, during calibration, the calibration unit 43 into the optical path LP of the beam L emitted from the exposure head 41, high-precision calibration can therefore be performed while the substrate 2 remains set on the conveying drum 33. Therefore, in the case of forming a continuous pattern on a long substrate, calibration can be performed, as needed.

Now, in the above-described example, the determination is made as to whether the measured value acquired in the calibration falls within the range of the reference value, and various types of processing for performing correction are executed if the measured value fails to fall within the range of the reference value. However, it may be sufficient to perform calibration and simply store the calibration data. Further, it may also be sufficient to store the determination result of the measured values acquired in the calibration, and/or the correction data based on the determination result.

Further, in the above-described example, the position and the inclination of the exposure head 41 are manually fine-adjusted by means of the adjustment stage 42, but an electrically controllable adjustment stage may be provided instead of the adjustment stage 42, and the position and the inclination of the exposure head 41 may be automatically adjusted based on the result of the calibration.

### First Variation

In the above-described example, a deviation in the irradiation position of the beam L is detected based on the detection signal output from the position detecting element 434; however, a focal spot deviation may be detected. Specifically, a spot diameter of the beam L may be acquired by extracting the irradiation range of the beam L in the light-receiving surface 435 based on the detection signal output from position detecting element 434. Then, the focal spot deviation is detected by comparing the acquired spot diameter with a spot diameter serving as a reference pre-stored in the reference data storage part 523.

In this case, an adjustment mechanism may be provided for adjusting the distance between each exposure head 41 and the conveying drum 33, and such distance may be adjusted based on the detected focal spot deviation. This enables the beam L to be focused with high precision on the light-receiving surface 435 of the position detecting element 434, i.e., the exposure surface of the substrate 2.

Further, a spot shape of the beam L in the light-receiving surface 435 may be acquired by extracting the irradiation range of the beam L in the light-receiving surface 435 based on the detection signal output from the position detecting element 434. In this case, the inclination of the exposure head 41 (i.e., the angle between the exposure surface of the substrate 2 and the beam L) may be corrected based on the acquired spot shape.

### Second Variation

In the above-described example, the calibration unit 43 is provided with the reflecting mirror 431; however, a beam splitter (half mirror) may be used instead of the reflecting mirror 431, and only part of the beam L emitted from the exposure head 41 may be reflected and guided to the sensor unit 432. Here, depending on the type of optical sensor in the sensor unit 432, such as the position detecting element 434 and the light intensity detecting element 436, the optical sensor may be damaged due to the excess power of the beam L. Therefore, by reflecting only part of the beam L with the beam splitter, the dimmed beam may be made to enter the optical sensor. In this case, the reference data storage part 523 may store a value that is set by considering the reflectance of the beam splitter as the reference data for the irradiation intensity.

### Embodiment of the invention

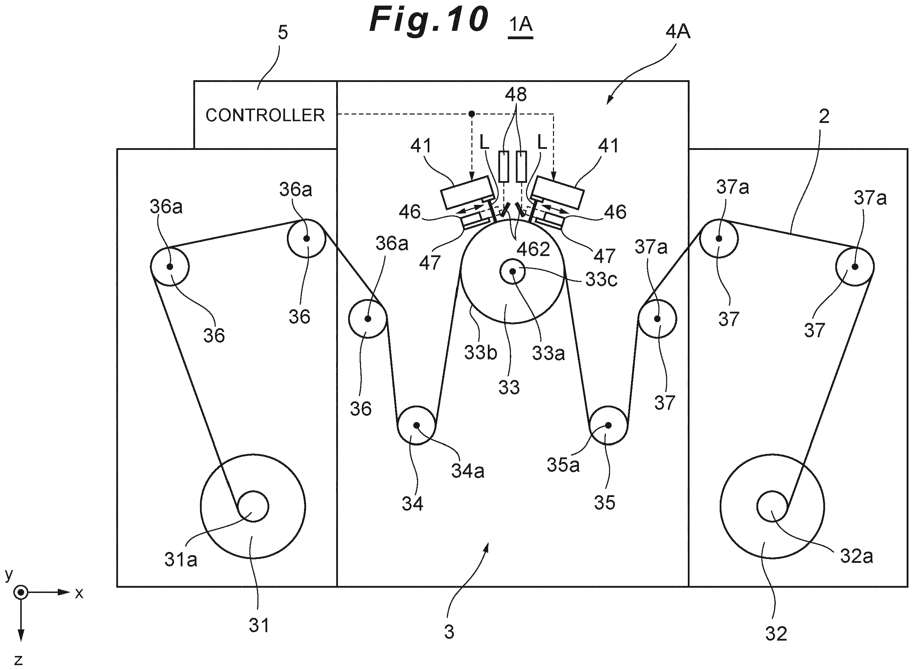

FIG. 10 is a schematic diagram showing a schematic configuration of a drawing device including a calibration system according to an embodiment of the present invention. As shown in FIG. 10, the drawing device 1A according to the present embodiment includes a drawing unit 4A instead of the drawing unit 4 shown in FIG. 1. In the drawing unit 4A, a plurality of exposure heads 41 that emit beams L for exposure toward the substrate 2, and mirror units 46, movement mechanisms 47, reflecting mirrors 462, and calibration units 48, which are used when calibrating the beams L, are provided. In the present embodiment, these mirror unit 46, movement mechanism 47, reflecting mirror 462, and calibration unit 48, together with the controller 5 described above, constitute the calibration system. The configuration of the respective components of the drawing device 1A, other than the calibration system, is similar to that of the above-described example. In this embodiment also, a mechanism may be further provided for adjusting the focus of the beam L by varying the distance between each exposure head 41 and the substrate 2, as with the above-described first variation.

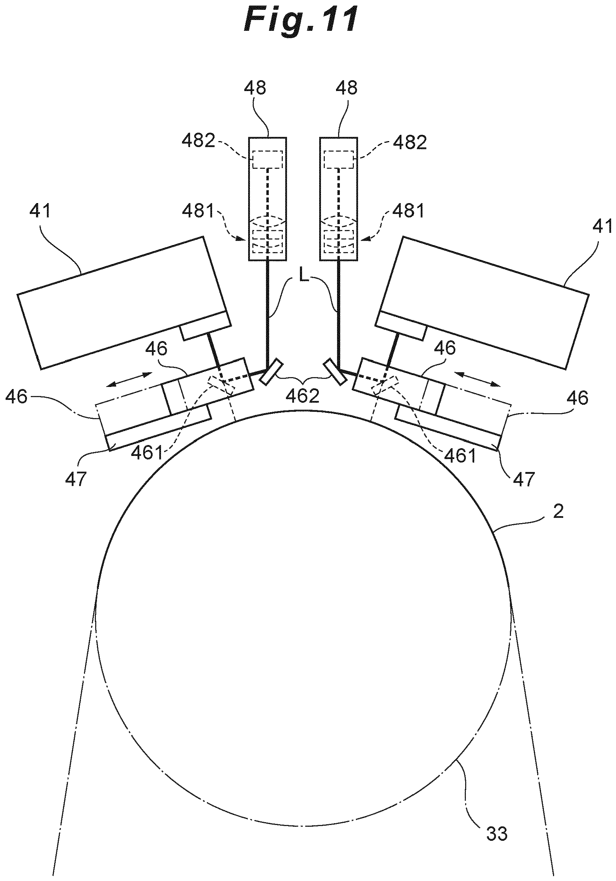

FIG. 11 is an enlarged schematic diagram showing a neighborhood of the calibration unit 48 shown in FIG. 10, and shows the arrangement at the time of calibration.

The movement mechanism 47 is, for example, a single-axis actuator, and inserts the mirror unit 46 into the optical path LP of the beam L at the start of calibration (see FIG. 11) and removes the mirror unit 46 from the optical path LP when the calibration is completed (see FIG. 10). The configuration of the movement mechanism 47 is not particularly limited, as long as it can move the mirror unit 46 with high precision. In addition, the direction in which the mirror unit 46 is moved is not limited to the direction of conveyance of the substrate 2 (the tangential direction of the outer periphery of the conveying drum 33) at the irradiation position of the beam L, and the mirror unit 46 may be moved, for example, along the width direction (y direction) of the substrate 2.

A reflecting mirror 461 is provided in the mirror unit 46. The reflecting mirror 461 is an optical system that is arranged on the optical path LP when the mirror unit 46 is inserted into the optical path LP and guides the beam L in a direction different from that of the optical path LP. As with the above-described second variation, a beam splitter (half mirror) may be provided instead of the reflecting mirror 461.

The reflecting mirror 462 and the calibration unit 48 are located at predetermined positions within the drawing unit 4A. The reflecting mirror 462 is a second optical system that further reflects the beam L reflected by the reflecting mirror 461 inserted on the optical path LP, and guides the beam L toward the calibration unit 48. Although the second optical system is configured by a single reflecting mirror 462 in FIG. 11, a plurality of mirrors and the like may be used to configure the second optical system. Further, as with the above-described second variation, a beam splitter (half mirror) may be used, instead of the reflecting mirror 462, to dim the beam L that enters the calibration unit 48.

An imaging optical system 481 and a sensor unit 482 are provided in the calibration unit 48. Among which, the configuration of the sensor unit 482 is similar to the configuration of the sensor unit 432 described in the example (see FIG. 7).

The imaging optical system 481 is a third optical system that allows the beam L reflected by the reflecting mirror 462 to be imaged on a light-receiving surface of an optical sensor in the sensor unit 482, such as a position detecting element and a light intensity detecting element. The light-receiving surface of the optical sensor in the sensor unit 482 and the exposure surface of the substrate 2 to be exposed by the beam L are conjugated and therefore, at the light-receiving surface of the sensor unit 482 when the mirror unit 46 is inserted into the optical path LP, the same image of the beam L can be obtained as that at the exposure surface of the substrate 2 when the mirror unit 46 is not inserted into the optical path LP. Although a plurality of optical elements are shown as the imaging optical system 481 in FIG. 11, the third optical system may be configured with a single lens.

Such mirror unit 46, movement mechanism 47, reflecting mirror 462, and calibration unit 48 are provided for each exposure head 41.

The overall operation of the drawing device 1A according to the present embodiment at the time of calibration is similar to that of the above example (see FIG. 9), except that, in step S12 of FIG. 9, the mirror unit 46 is inserted into the optical path LP and in step S17, the mirror unit 46 is removed from the optical path LP.

The present invention as thus far described is not limited to the above-described embodiment, but by the appended claims.

### DESCRIPTION OF REFERENCE NUMBERS

1, 1A... drawing device; 2... substrate; 3... conveying system; 4, 4A... drawing unit; 5...controller; 21...exposure pattern; 22a to 22d... identification marks; 31, 32... reels; 31a, 32a, 33a, 34a, 35a, 36a, 37a, 414a... rotary shafts; 33... conveying drum; 33c... encoder; 33b... outer periphery; 34, 35... tension pulleys; 36, 37... guide rollers; 41... exposure head; 41a... beam emitting port; 42... adjustment stage; 43, 48... calibration unit; 44, 47... movement mechanism; 46... mirror unit; 51... external interface; 52... storage part; 53... control part; 61... substrate conveying drive device; 62... calibration-use drive device; 63... input device; 64... display device; 65... data reading-in device; 411... laser light source; 412... beam-shaping optical system; 413, 431, 461, 462... reflecting mirrors; 414... polygon mirror; 415, 481... imaging optical systems; 432, 482... sensor units; 433... sensor substrate; 434... position detecting element; 435... light-receiving surface; 436... light intensity detecting element; 521... program storage part; 522... pattern data storage part; 523... reference data storage part; 524... calibration data storage part; 525... correction data storage part; 531... drawing control part; 532... calibration control part; 533... determination part; 534... correction part

## Claims

1. A calibration system for performing calibration in a drawing device (1A), the drawing device (1A) comprising at least one exposure head (41) configured to emit a beam (L) for exposure toward an exposure surface (P1) of a substrate (2), the substrate (2) having a long-sheet shape and being conveyed in a longitudinal direction by being supported on part of an outer periphery (33b) of a conveying drum (33) having a cylindrical shape, comprising:
an optical system (461) that is provided insertably into and removably from an optical path of the beam (L) that is emitted from the exposure head (41) and enters the exposure surface (P1), the optical system (461) configured to guide at least part of the beam (L) in a direction different from that of the optical path when the optical system (461) is inserted into the optical path;
a movement mechanism (47) configured to insert and remove the optical system (461) into and from the optical path; and
an optical sensor (482) having a light-receiving surface for receiving at least part of the beam (L) that is guided by the optical system (461) when the optical system (461) is inserted into the optical path, the optical sensor (482) being configured to output a detection signal by detecting an irradiation position and an irradiation intensity at the light-receiving surface of at least part of the beam (L) that has entered the light-receiving surface,
**characterized by** the position of the optical sensor (482) being fixed, and
the calibration system further comprising:
a second optical system (462) configured to guide at least part of the beam (L), guided by the optical system (461) in a direction different from that of the optical path, in a direction toward the light-receiving surface of the optical sensor (482); and
a third optical system (481) configured to allow at least part of the beam (L) guided by the second optical system (462) to be imaged on the light-receiving surface.

2. The calibration system of claim 1, wherein the exposure surface (P1) when the optical system (461) is removed from the optical path and the light-receiving surface when the optical system (461) is inserted into the optical path are conjugated.

3. The calibration system of claim 1 or 2, further comprising:
a control part (53) configured to generate, based on the detection signal output from the optical sensor (482), data representing an irradiation position and an irradiation intensity at the light-receiving surface of at least part of the beam (L) emitted from the exposure head (41); and
a storage part (52) configured to store the data representing the irradiation position and the irradiation intensity as calibration data.

4. The calibration system of claim 3, wherein the storage part (52) is further configured to store reference data representing a reference irradiation position and a reference irradiation intensity at the light-receiving surface corresponding to a predetermined irradiation position and a predetermined irradiation intensity of the beam (L) at the exposure surface (P1), and
the control part (53) includes a determination part (533) configured to determine, based on the calibration data and the reference data, whether an irradiation position and an irradiation intensity of a beam (L) that has entered the light-receiving surface fall within ranges of predetermined reference values.

5. The calibration system of claim 4, wherein the control part (53) is configured to generate, based on the determination result by the determination part (533), correction value data for correcting at least either the irradiation position or the irradiation intensity of the beam (L) emitted from the exposure head (41) if at least either the irradiation position or the irradiation intensity of the beam (L) that has entered the light-receiving surface fails to fall within the range of the reference value, and
the storage part (52) is further configured to store the correction value data.

6. The calibration system of claim 5, wherein the exposure head (41) includes:
a light source (411) configured to output laser light;
a beam-shaping optical system (412) configured to generate a beam by shaping the laser light into a beam shape;
a polygon mirror (414) configured to cause the beam generated by the beam-shaping optical system (412) to scan; and
a drive part configured to rotate the polygon mirror (414), wherein
the control part (53) is configured to correct at least either the irradiation intensity or the irradiation position of the beam (L) emitted from the exposure head (41) by controlling at least either the output of the light source (411) or operation of the drive part based on the correction value data.

7. The calibration system of any one of claims 3 to 6, further comprising an adjustment mechanism configured to adjust the distance between the exposure head (41) and the conveying drum (33), wherein the control part (53) is configured to acquire, based on the detection signal representing the irradiation position of the beam (L) output from the optical sensor (482), the diameter of the beam (L) at the light-receiving surface and to control the adjustment mechanism based on the diameter of the beam (L).

8. A drawing device (1A) comprising:
a conveying drum (33) that has a cylindrical shape, the conveying drum (33) being configured to support a long sheet-like substrate (2) on part of an outer periphery (33b) and to convey the substrate (2) by rotating about a central shaft of the cylinder;
at least one exposure head (41) configured to emit a beam (L) for exposure toward an exposure surface (P1) of the substrate (2); and
at least one calibration system configured to perform calibration of the at least one exposure head (41), wherein
the calibration system includes:
an optical system (461) that is provided insertably into and removably from an optical path of the beam (L) that is emitted from the exposure head (41) and enters the exposure surface (P1), the optical system (461) configured to guide at least part of the beam (L) in a direction different from that of the optical path when the optical system (461) is inserted into the optical path;
a movement mechanism (47) configured to insert and remove the optical system (461) into and from the optical path; and
an optical sensor (482) having a light-receiving surface for receiving at least part of the beam (L) that is guided by the optical system (461) when the optical system (461) is inserted into the optical path, the optical sensor (482) being configured to output a detection signal by detecting an irradiation position and an irradiation intensity at the light-receiving surface of at least part of the beam (L) that has entered the light-receiving surface, **characterized by** the position of the optical sensor (482) being fixed, and
the calibration system further comprising:
a second optical system (462) configured to guide at least part of the beam (L), guided by the optical system (461) in a direction different from that of the optical path, in a direction toward the light-receiving surface of the optical sensor (482); and
a third optical system (481) configured to allow at least part of the beam (L) guided by the second optical system (462) to be imaged on the light-receiving surface.

## Patentansprüche

1. Kalibriersystem zum Durchführen einer Kalibrierung in einer Zeichenvorrichtung (1A), wobei die Zeichenvorrichtung (1A) mindestens einen Belichtungskopf (41) umfasst, der dazu aufgebaut ist, einen Strahl (L) zur Belichtung in Richtung einer Belichtungsoberfläche (P1) eines Substrats (2) zu emittieren, wobei das Substrat (2) eine Form eines langen Blatts aufweist und in einer Längsrichtung befördert wird, indem es auf einem Teil eines Außenumfangs (33b) einer Fördertrommel (33) mit einer zylindrischen Form geführt wird, mit:
einem optischen System (461), das in einen optischen Pfad des Strahls (L), der von dem Belichtungskopf (41) emittiert wird und in die Belichtungsfläche (P1) eintritt, einführbar und aus diesem entfernbar vorgesehen ist, wobei das optische System (461) dazu aufgebaut ist, zumindest einen Teil des Strahls (L) in eine Richtung zu lenken, die sich von der des optischen Pfads unterscheidet, wenn das optische System (461) in den optischen Pfad eingeführt ist;
einem Bewegungsmechanismus (47), der dazu aufgebaut ist, das optische System (461) in den Strahlengang einzuführen und aus diesem zu entfernen; und
einem optischen Sensor (482) mit einer Lichtempfangsfläche zum Empfangen mindestens eines Teils des Strahls (L), der durch das optische System (461) geführt wird, wenn das optische System (461) in den optischen Weg eingefügt ist, wobei der optische Sensor (482) dazu aufgebaut ist, ein Erfassungssignal durch Erfassen einer Bestrahlungsposition und einer Bestrahlungsintensität an der Lichtempfangsfläche von mindestens einem Teil des Strahls (L) auszugeben, der in die Lichtempfangsfläche eingetreten ist,
**dadurch gekennzeichnet, dass**
die Position des optischen Sensors (482) fest ist, und das Kalibriersystem zudem Folgendes umfasst:
ein zweites optisches System (462), das dazu aufgebaut ist, zumindest einen Teil des Strahls (L), der durch das optische System (461) in einer Richtung geführt wird, die sich von der des optischen Weges unterscheidet, in eine Richtung zur Lichtempfangsfläche des optischen Sensors (482) zu lenken; und
ein drittes optisches System (481), das so aufgebaut ist, dass zumindest ein Teil des durch das zweite optische System (462) geführten Strahls (L) auf der lichtempfangenden Oberfläche abbildbar ist.

2. Kalibriersystem nach Anspruch 1, wobei die Belichtungsfläche (P1), wenn das optische System (461) aus dem Strahlengang entfernt ist, und die Lichtempfangsfläche, wenn das optische System (461) in den Strahlengang eingefügt ist, konjugiert sind.

3. Kalibriersystem nach Anspruch 1 oder 2, weiter mit:
einem Steuerteil (53), das dazu aufgebaut ist, auf der Grundlage des vom optischen Sensor (482) ausgegebenen Erfassungssignals Daten zu erzeugen, die eine Bestrahlungsposition und eine Bestrahlungsintensität an der Lichtempfangsfläche von zumindest einem Teil des vom Belichtungskopf (41) emittierten Strahls (L) wiedergeben; und
einem Speicherteil (52), das dazu aufgebaut ist, die Daten, die die Bestrahlungsposition und die Bestrahlungsintensität darstellen, als Kalibrierungsdaten zu speichern.

4. Kalibriersystem nach Anspruch 3, wobei das Speicherteil (52) zudem dazu aufgebaut ist, Referenzdaten zu speichern, die eine Referenzbestrahlungsposition und eine Referenzbestrahlungsintensität an der Lichtempfangsfläche darstellen, die einer vorab festgelegten Bestrahlungsposition und einer vorab festgelegten Bestrahlungsintensität des Strahls (L) an der Belichtungsfläche (P1) entsprechen, und
das Steuerteil (53) ein Bestimmungsteil (533) enthält, das dazu aufgebaut ist, basierend auf den Kalibrierungsdaten und den Referenzdaten zu bestimmen, ob eine Bestrahlungsposition und eine Bestrahlungsintensität eines Strahls (L), der in die Lichtempfangsfläche eingetreten ist, in Bereiche vorbestimmter Referenzwerte fallen.

5. Kalibriersystem nach Anspruch 4, wobei das Steuerteil (53) dazu aufgebaut ist, basierend auf dem Bestimmungsergebnis durch den Bestimmungsteil (533) Korrekturwertdaten zum Korrigieren zumindest entweder der Bestrahlungsposition oder der Bestrahlungsintensität des vom Belichtungskopf (41) emittierten Strahls (L) zu erzeugen, wenn zumindest entweder die Bestrahlungsposition oder die Bestrahlungsintensität des in die Lichtempfangsfläche eingetretenen Strahls (L) nicht in den Bereich des Referenzwerts fällt, und das Speicherteil (52) zudem dazu aufgebaut ist, die Korrekturwertdaten zu speichern.

6. Kalibriersystem nach Anspruch 5, wobei der Belichtungskopf (41) Folgendes umfasst:
eine Lichtquelle (411), die dazu aufgebaut ist, Laserlicht auszugeben;
ein optisches Strahlformungssystem (412), das dazu aufgebaut ist, einen Strahl zu erzeugen, indem es das Laserlicht in eine Strahlform formt,
einen Polygonspiegel (414), der dazu aufgebaut ist, den von dem strahlformenden optischen System (412) erzeugten Strahl zu Abtasten zu veranlassen; und
ein Antriebsteil, das dazu aufgebaut ist, den Polygonspiegel (414) zu drehen, wobei
das Steuerteil (53) dazu aufgebaut ist, zumindest entweder die Bestrahlungsintensität oder die Bestrahlungsposition des von dem Belichtungskopf (41) emittierten Strahls (L) zu korrigieren, indem es zumindest entweder die Abgabe der Lichtquelle (411) oder den Betrieb des Antriebsteils basierend auf den Korrekturwertdaten steuert.

7. Kalibriersystem nach einem der Ansprüche 3 bis 6, das zudem einen Einstellmechanismus umfasst, der dazu aufgebaut ist, den Abstand zwischen dem Belichtungskopf (41) und der Transporttrommel (33) einzustellen, wobei
das Steuerteil (53) dazu aufgebaut ist, basierend auf dem vom optischen Sensor (482) ausgegebenen Erfassungssignal, das die Bestrahlungsposition des Strahls (L) wiedergibt, den Durchmesser des Strahls (L) an der Lichtempfangsfläche zu erfassen und den Einstellmechanismus basierend auf dem Durchmesser des Strahls (L) zu steuern.

8. Zeichenvorrichtung (1A), die Folgendes umfasst:
eine Fördertrommel (33), die eine zylindrische Form aufweist, wobei die Fördertrommel (33) dazu aufgebaut ist, ein langes blattartiges Substrat (2) auf einem Teil eines Außenumfangs (33b) zu tragen und das Substrat (2) durch Drehen um eine Mittelwelle des Zylinders zu bewegen;
mindestens einen Belichtungskopf (41), der dazu aufgebaut ist, einen Strahl (L) zur Belichtung auf eine Belichtungsoberfläche (P1) des Substrats (2) zu emittieren; und mindestens ein Kalibriersystem, das dazu aufgebaut ist, eine Kalibrierung des mindestens einen Belichtungskopfs (41) durchzuführen, wobei
das Kalibriersystem Folgendes umfasst:
ein optisches System (461), das in einen optischen Pfad des vom Belichtungskopf (41) emittierten und in die Belichtungsoberfläche (P1) eintretenden Strahls (L) einführbar und aus diesem entfernbar vorgesehen ist, wobei das optische System (461) dazu aufgebaut ist, zumindest einen Teil des Strahls (L) in eine Richtung zu lenken, die sich von derjenigen des optischen Pfads unterscheidet, wenn das optische System (461) in den optischen Pfad eingeführt ist;
einen Bewegungsmechanismus (47), der dazu aufgebaut ist, das optische System (461) in den Strahlengang einzuführen und aus diesem zu entfernen; und
einen optischen Sensor (482) mit einer Lichtempfangsfläche zum Empfangen mindestens eines Teils des durch das optische System (461) geführten Strahls (L), wenn das optische System (461) in den optischen Pfad eingeführt ist, wobei der optische Sensor (482) dazu aufgebaut ist, ein Erfassungssignal durch Erfassen einer Bestrahlungsposition und einer Bestrahlungsintensität an der Lichtempfangsfläche von mindestens einem Teil des in die Lichtempfangsfläche eingetretenen Strahls (L) auszugeben,
**dadurch gekennzeichnet, dass**
die Position des optischen Sensors (482) fest ist, und
das Kalibriersystem außerdem Folgendes umfasst:
ein zweites optisches System (462), das dazu aufgebaut ist, zumindest einen Teil des Strahls (L), der vom optischen System (461) in einer Richtung geführt wird, die sich von der des optischen Pfads unterscheidet, in eine Richtung zur Lichtempfangsfläche des optischen Sensors (482) zu führen; und
ein drittes optisches System (481), das dazu aufgebaut ist, zu ermöglichen, dass zumindest ein Teil des durch das zweite optische System (462) geführten Strahls (L) auf der Lichtempfangsfläche abgebildet wird.

## Revendications

1. Système d'étalonnage pour réaliser l'étalonnage dans un dispositif de dessin (1A), le dispositif de dessin (1A) comprenant au moins une tête d'exposition (41) configurée pour émettre un faisceau (L) pour une exposition vers une surface d'exposition (P1) d'un substrat (2), le substrat (2) présentant une forme de feuille longue et étant transporté dans une direction longitudinale en étant supporté sur une partie d'une périphérie externe (33b) d'un tambour de transport (33) présentant une forme cylindrique, comprenant :
un système optique (461) qui est fourni de manière à pouvoir être inséré dans et être retiré d'un trajet optique du faisceau (L) qui est émis par la tête d'exposition (41) et entre dans la surface d'exposition (P1), le système optique (461) étant configuré pour guider au moins une partie du faisceau (L) dans une direction différente de celle du trajet optique lorsque le système optique (461) est inséré dans le trajet optique ;
un mécanisme de déplacement (47) configuré pour insérer le système optique (461) dans le trajet optique et l'en retirer ; et
un capteur optique (482) présentant une surface de réception de lumière pour recevoir au moins une partie du faisceau (L) qui est guidé par le système optique (461) lorsque le système optique (461) est inséré dans le trajet optique, le capteur optique (482) étant configuré pour délivrer un signal de détection par détection d'une position d'émission et d'une intensité d'émission au niveau de la surface de réception de lumière d'au moins une partie du faisceau (L) qui est entré dans la surface de réception de lumière,
**caractérisé par le fait que** la position du capteur optique (482) est fixe, et
le système d'étalonnage comprenant en outre :
un deuxième système optique (462) configuré pour guider au moins une partie du faisceau (L), guidé par le système optique (461) dans une direction différente de celle du trajet optique, dans une direction vers la surface de réception de lumière du capteur optique (482) ; et
un troisième système optique (481) configuré pour permettre à au moins une partie du faisceau (L) guidé par le deuxième système optique (462) d'être mise en image sur la surface de réception de lumière.

2. Système d'étalonnage selon la revendication 1, dans lequel la surface d'exposition (P1) lorsque le système optique (461) est retiré du trajet optique et la surface de réception de lumière lorsque le système optique (461) est inséré dans le trajet optique sont conjuguées.

3. Système d'étalonnage selon la revendication 1 ou 2, comprenant en outre :
une partie de commande (53) configurée pour générer, sur la base du signal de détection délivré par le capteur optique (482), des données représentant une position d'émission et une intensité d'émission au niveau de la surface de réception de lumière d'au moins une partie du faisceau (L) émis par la tête d'exposition (41) ; et
une partie de stockage (52) configurée pour stocker les données représentant la position d'émission et l'intensité d'émission en tant que données d'étalonnage.

4. Système d'étalonnage selon la revendication 3, dans lequel la partie de stockage (52) est en outre configurée pour stocker des données de référence représentant une position d'émission de référence et une intensité d'émission de référence au niveau de la surface de réception de lumière correspondant à une position d'émission prédéterminée et à une intensité d'émission prédéterminée du faisceau (L) au niveau de la surface d'exposition (P1), et
la partie de commande (53) inclut une partie de détermination (533) configurée pour déterminer, sur la base des données d'étalonnage et des données de référence, si une position d'émission et une intensité démission d'un faisceau (L) qui est entré dans la surface de réception de lumière sont comprises dans des plages de valeurs de référence prédéterminées.

5. Système d'étalonnage selon la revendication 4, dans lequel la partie de commande (53) est configurée pour générer, sur la base du résultat de détermination par la partie de détermination (533), des données de valeur de correction pour corriger au moins soit la position d'émission, soit l'intensité d'émission du faisceau (L) émis par la tête d'exposition (41) si au moins soit la position d'émission, soit l'intensité d'émission du faisceau (L) qui est entré dans la surface de réception de lumière n'est pas comprise dans la plage de la valeur de référence, et
la partie de stockage (52) est en outre configurée pour stocker les données de valeur de correction.

6. Système d'étalonnage selon la revendication 5, dans lequel la tête d'exposition (41) inclut :
une source de lumière (411) configurée pour délivrer une lumière laser ;
un système optique de formation de faisceau (412) configuré pour générer un faisceau par mise en forme de la lumière laser en une forme de faisceau ;
un miroir polygonal (414) configuré pour amener le faisceau généré par le système optique de formation de faisceau (412) à balayer ; et
une partie d'entraînement configuré pour faire pivoter le miroir polygonal (414), dans lequel
la partie de commande (53) est configurée pour corriger au moins soit l'intensité d'émission, soit la position d'émission du faisceau (L) émis par la tête d'exposition (41) par commande d'au moins soit la sortie de la source de lumière (411), soit le fonctionnement de la partie d'entraînement sur la base des données de valeur de correction.

7. Système d'étalonnage selon l'une quelconque des revendications 3 à 6, comprenant en outre un mécanisme d'ajustement configuré pour ajuster la distance entre la tête d'exposition (41) et le tambour de transport (33), dans lequel
la partie de commande (53) est configurée pour acquérir, sur la base du signal de détection représentant la position d'émission du faisceau (L) délivré par le capteur optique (482), le diamètre du faisceau (L) au niveau de la surface de réception de lumière et pour commander le mécanisme d'ajustement sur la base du diamètre du faisceau (L).

8. Dispositif de dessin (1A) comprenant :
un tambour de transport (33) qui présente une forme cylindrique, le tambour de transport (33) étant configuré pour supporter un substrat stratiforme long (2) sur une partie d'une périphérie externe (33b) et pour transporter le substrat (2) par rotation autour d'un arbre central du cylindre ;
au moins une tête d'exposition (41) configurée pour émettre un faisceau (L) pour une exposition vers une surface d'exposition (P1) du substrat (2) ; et
au moins un système d'étalonnage configuré pour réaliser l'étalonnage de la au moins une tête d'exposition (41), dans lequel
le système d'étalonnage inclut :
un système optique (461) qui est fourni de manière à pouvoir être inséré dans et être retiré d'un trajet optique du faisceau (L) qui est émis par la tête d'exposition (41) et entre dans la surface d'exposition (P1), le système optique (461) étant configuré pour guider au moins une partie du faisceau (L) dans une direction différente de celle du trajet optique lorsque le système optique (461) est inséré dans le trajet optique ;
un mécanisme de déplacement (47) configuré pour insérer le système optique (461) dans le trajet optique et l'en retirer ; et
un capteur optique (482) présentant une surface de réception de lumière pour recevoir au moins une partie du faisceau (L) qui est guidé par le système optique (461) lorsque le système optique (461) est inséré dans le trajet optique, le capteur optique (482) étant configuré pour délivrer un signal de détection par détection d'une position d'émission et d'une intensité d'émission au niveau de la surface de réception de lumière d'au moins une partie du faisceau (L) qui est entré dans la surface de réception de lumière,
**caractérisé par le fait que** la position du capteur optique (482) est fixe, et
le système d'étalonnage comprenant en outre :
un deuxième système optique (462) configuré pour guider au moins une partie du faisceau (L), guidé par le système optique (461) dans une direction différente de celle du trajet optique, dans une direction vers la surface de réception de lumière du capteur optique (482) ; et
un troisième système optique (481) configuré pour permettre à au moins une partie du faisceau (L) guidé par le deuxième système optique (462) d'être mise en image sur la surface de réception de lumière.
